# EUROPEAN PATENT APPLICATION

(11) **EP 4 560 337 A1**
(43) Date of publication of application: **28.05.2025**
(21) Application number: 24823514.5
(22) Date of filing: 26.02.2024
(51) Int. Cl.: G01R 31/392, G01R 31/389, G01N 27/02, H05B 1/02, H05B 6/02

(54) **APPARATUS AND METHOD FOR INSPECTING DEFECT OF BATTERY CELL, AND SYSTEM COMPRISING SAME**

(30) Priority: 16.06.2023 KR 20230077226
(71) Applicant: LG Energy Solution, Ltd., Seoul 07335 (KR)
(72) Inventor: CHO, Inhwan, Daejeon 34122 (KR); KANG, Juyoung, Daejeon 34122 (KR); KIM, Ju Young, Daejeon 34122 (KR); PARK, Sang Dae, Daejeon 34122 (KR); LEE, Dajin, Daejeon 34122 (KR)
(74) Representative: Goddar, Heinz J.
(86) International application number: PCT/KR2024/002443
(87) International publication number: WO 2024/257992

(57) **Abstract**

An apparatus and a method for inspecting a defect of a battery cell, and a system comprising same, according to an embodiment and an experimental example of the present invention, can calculate a difference value of resistance values measured in a metal part before and after heat generation with respect to the battery cell, and compare the difference value with a preset reference value to determine whether a defect occurs in the metal part in the battery cell.

## Description

This application claims priority to and the benefit of Korean Patent Application No.10-2023-0077226 filed in the Korean Intellectual Property Office on June 16, 2023 the entire contents of which are incorporated herein by reference.

### [Technical Field]

The present invention relates to an apparatus and method of inspecting a battery cell for defects, and a system including the apparatus, and more particularly, to an apparatus and method of inspecting a battery cell for defects, and a system including the apparatus, for inspecting defects occurring in a metal portion of a battery cell.

### [Background Art]

As depletion of fossil fuels proceeds and interest in environmental pollution increases, a demand for secondary batteries as an eco-friendly alternative energy source is rapidly increasing. Among various alternative energy sources, demand for rechargeable lithium secondary batteries is rapidly increasing.

Lithium secondary batteries are being applied to various industrial fields from mobile application devices to vehicles, robots and energy storage devices, as a response to today's environmental regulations and high oil price issues. Meanwhile, lithium batteries are easily exposed to external shocks, vibrations, etc.

Accordingly, defect inspection is essential for lithium batteries to ensure high performance and stability. Among them, if a defect occurs in a metal portion of the battery that is electrically connected to the outside, performance and safety are greatly reduced, so inspection of the metal portion for defects is essential.

In general, defect inspection of metal portions may include inspection of tab disconnection and inspection of weld defects.

Conventional defect inspection of metal portions may involve disassembling a battery cell that has been manufactured and performing a vision inspection, or using CT imaging for non-destructive inspection to visually determine defects.

However, when visually determining whether a metal portion is defective, there is a disadvantage that it is difficult to accurately judge quality because the judgment criteria are ambiguous. Additionally, the method of inspecting defective in metal portions through CT imaging has a disadvantage of requiring a long time for imaging and determination.

Recently, an inspection method that determines defects by measuring the resistance between welded surfaces using a probe pin has been used. However, the weld inspection method using a probe pin has a disadvantage in that the weld surface is curved due to welding, making contact with the probe pin difficult, resulting in a high incidence of mis-inspection. In addition, in the case of defects such as weak welding and partial disconnection of tabs, the change in resistance is small, causing a disadvantage of being incorrectly detected as a normal battery cell.

### [Detailed Description of the Invention]

### [Technical Problem]

To obviate one or more problems of the related art, embodiments of the present disclosure provide a method of inspecting a battery cell for defects.

To obviate one or more problems of the related art, embodiments of the present disclosure provide a defect inspection apparatus of a battery cell.

To obviate one or more problems of the related art, embodiments of the present disclosure also provide a defect inspection system of a battery cell.

### [Technical Solution]

In order to achieve the objective of the present disclosure, a method of inspecting a battery cell for defects may include calculating a difference between resistance values measured before and after inducing heat generation of a metal portion in the battery cell; and comparing the difference with a predetermined reference value to determine whether a defect occurs in the metal portion.

The calculating the difference between the resistance values may include obtaining a first resistance value of the metal portion before inducing the heat generation; inducing heat generation in the metal portion according to heat generation condition; obtaining a second resistance value of the metal portion where the heat generation is induced; and comparing the first resistance value and the second resistance value to calculate the difference.

Here, the heat generation condition may include at least one condition value that ensures that a temperature change of an electrolyte in the battery cell is maintained below a predetermined reference level.

In addition, the inducing heat generation in the metal portion according to the heat generation condition may include inducing heat generation in the metal portion by charging and discharging the battery cell according to the heat generation condition.

For example, the heat generation condition may include at least one of a magnitude of a charge/discharge current, a charge/discharge time, and external temperature, for charging and discharging the battery cell.

Here, the heat generation condition may differ according to information on attributes of the battery cell.

Meanwhile, the resistance values may be values of real part in impedance values measured at a predefined frequency.

In addition, the comparing the difference with a predetermined reference value to determine whether a defect occurs in the metal portion may include, upon the difference being greater than or equal to the reference value, determining that a defect has occurred in the metal portion; and upon the difference being less than the reference value, determining that the battery cell is normal.

According to another embodiment of the present disclosure, a defect inspection apparatus of a battery cell may include at least one processor; and a memory configured to store at least one instruction executed by the at least one processor, and the at least one instruction may include an instruction to calculate a difference between resistance values measured before and after inducing heat generation of a metal portion in the battery cell; and an instruction to compare the difference with a predetermined reference value to determine whether a defect occurs in the metal portion.

Here, the instruction to calculate the difference between the resistance values may include an instruction to obtain a first resistance value of the metal portion before inducing the heat generation; an instruction to induce heat generation in the metal portion according to heat generation condition; an instruction to obtain a second resistance value of the metal portion where the heat generation is induced; and an instruction to compare the first resistance value and the second resistance value to calculate the difference.

Here, the heat generation condition may include at least one condition value that ensures that a temperature change of an electrolyte in the battery cell is maintained below a predetermined reference level.

In addition, the instruction to induce heat generation in the metal portion according to the heat generation condition may include an instruction to induce heat generation in the metal portion by charging and discharging the battery cell according to the heat generation condition.

For, example, the heat generation condition includes at least one of a magnitude of a charge/discharge current, a charge/discharge time, and external temperature, for charging and discharging the battery cell.

Here, the heat generation condition may vary according to information on attributes of the battery cell.

Meanwhile, the resistance values may be values of real part in impedance values measured at a predefined frequency.

Furthermore, the instruction to compare the difference with a predetermined reference value to determine whether a defect occurs in the metal portion includes: an instruction to, upon the difference being greater than or equal to the reference value, determine that a defect has occurred in the metal portion; and an instruction to, upon the difference being less than the reference value, determine that the battery cell is normal.

According to another embodiment of the present disclosure, a defect inspection system of a battery cell may include an impedance measurement device configured to measure a resistance value of a battery cell; a heat generation device configured to induce heat generation from a metal portion of the battery cell; and a defect inspection apparatus of a battery cell configured to determine whether a defect occurs in the metal portion of the battery cell, wherein the defect inspection apparatus of a battery cell is further configured to: calculate difference between resistance values which are measured before and after inducing heat in the metal portion by the impedance measuring device; and compare the difference with a predetermined reference value to check whether a defect occurs in the metal portion.

Here, the defect inspection apparatus of a battery cell may further be configured to: obtain a first resistance value of the metal portion from the impedance measuring device before inducing heat in the metal portion; transmit heat generation condition to the heat generation device to induce heat generation in the metal portion; obtain a second resistance value of the metal portion in which the heat generation is induced from the impedance measuring device; and compare the first resistance value and the second resistance value to calculate the difference, to determine whether a defect occurs in the metal portion.

Here, the heat generation condition may include at least one condition value that ensures that a temperature change of an electrolyte in the battery cell is maintained below a predetermined reference level.

Meanwhile, the heat generation device may include a charging/discharging device.

Furthermore, the resistance values may be values of real part in impedance values measured at a predefined frequency.

### [Advantageous Effects]

An apparatus and method for inspecting defective battery cells according to embodiments and experimental examples of the present invention, and a system including the same, may induce heat generation in a battery cell to be inspected and compare impedance measurement values before and after heat generation, so that resistance change of a metal portion inside a defective battery cell increases due to the heat generation, thereby providing a highly reliable inspection for defects.

### [Brief Description of theDrawings]

FIG. 1 is a block diagram of a defect inspection system of battery cells according to embodiments of the invention.
FIG. 2 is a block diagram of a processor in the defect inspection apparatus according to embodiments of the present invention.
FIG. 3 is a flowchart for explaining a method of inspecting a battery cell for defects using a defect inspection apparatus according to embodiments of the present invention.
FIG. 4 is a conceptual diagram of a defect inspection system for inspecting a pouch-type battery cell according to an experimental example of the present invention.
FIG. 5 is an image measuring the temperature of a defective battery cell when heat is induced according to an experimental example of the present invention.
FIG. 6 is a graph of impedance measurement results per frequency of a normal battery cell before and after heat generation according to an experimental example of the present invention.
FIG. 7 is a graph of impedance measurement results per frequency of a defective battery cell before and after heat generation according to another experimental example of the present invention.
FIG. 8 is a table summarizing resistance values before and after heat generation of normal battery cells and defective battery cells according to experimental examples of the present invention.

- 1000:: impedance measurement device
- 3000:: heat generation device
- 5000:: defect inspection apparatus
- 100:: memory
- 200:: processor
- 300:: transceiver
- 400:: input interface
- 500:: output interface
- 600:: storage device
- 700:: bus

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

Terms used in the present application are used only to describe specific embodiments, and are not intended to limit the present invention. A singular form includes a plural form if there is no clearly opposite meaning in the context. In the present application, it should be understood that the term "include" or "have" indicates that a feature, a number, a step, an operation, a component, a part or the combination thereof described in the specification is present, but does not exclude a possibility of presence or addition of one or more other features, numbers, steps, operations, components, parts or combinations thereof, in advance.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Hereinafter, preferred embodiments according to the present invention will be described in more detail with reference to the attached drawings.

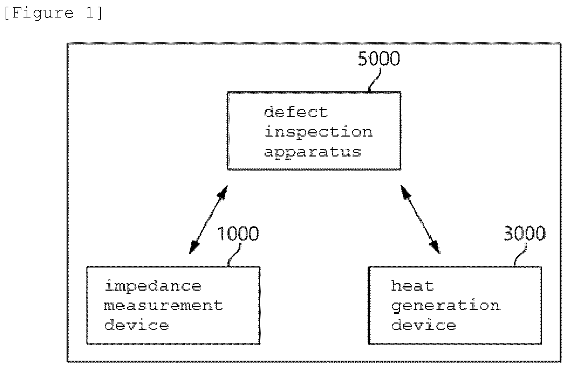

FIG. 1 is a block diagram of a defect inspection system of battery cells according to embodiments of the invention.

Referring to FIG. 1, the defect inspection system (S) of a battery cell according to embodiments of the present invention may induce heat generation in a battery cell to be inspected and detect at least one defect occurring in a metal portion inside the battery cell.

To be more specific, the defect inspection system of a battery cell may include an impedance measurement device (Electrochemical Impedance Spectroscopy: EIS) 1000, a heat generation device 3000, and a defect inspection apparatus of a battery cell 5000.

The impedance measurement device 1000 may measure resistance values of a battery cell before and after the heat generation.

To be described in more detail according to embodiments, the impedance measurement device 1000 may be connected to the anode and the cathode of the battery cell to be inspected, respectively.

For example, the battery cell may be located on a fixture that includes a plurality of measurement pins. More specifically, the battery cell may be positioned on the fixture with its positive and negative electrodes respectively in contact with one end of the plurality of measurement pins. Accordingly, the impedance measuring device 1000 may be connected to the other ends of a plurality of measurement pins, one ends of which are in contact with the positive and negative electrodes of the battery cell, respectively. Accordingly, the impedance measuring device 1000 may be electrically connected to the positive and negative electrodes of the battery cell, respectively. Here, the shape of the fixture may be provided in various forms that can improve fixing force depending on a shape of the battery cell to be measured such as a cylindrical, a pouch, or a stacked type.

Thereafter, the impedance measuring device 1000 may apply alternating voltage or alternating current to the battery cell, before and after heat generation. Accordingly, the impedance measurement device 1000 may measure changes in an amplitude and a phase of the alternating voltage or the alternating current passing through the battery cell and calculate impedance values for each frequency. For example, alternating voltage or the alternating current may be provided in the form of a sinusoidal wave.

The heat generation device 3000 may be a device that induces heat generation in a metal portion within the battery cell. To be more specific, the heat generation device 3000 may be electrically or physically connected to the battery cell and may induce heat generation in the metal portion according to predefined heat generation conditions. Here, the heat generation condition may be information on condition setting for minimizing temperature change in the electrolyte within the battery cell.

In other words, the defect inspection system of battery cells according to embodiments of the present invention may induce heat generation which is limited to the metal portion within the battery cell so that the temperature change of the electrolyte in the battery cell can be minimized according to heat generation conditions. Therefore, the defect inspection system of battery cells can prevent side reactions from occurring due to temperature changes in the electrolyte when inspecting the battery cell for defects.

Meanwhile, heat generation conditions may vary depending on attribute information of the battery cell. For example, the attribute information of a battery cell is an element that determines a battery model and may include a type, material of the metal portion, number of tabs, etc.

According to embodiments, the heat generation device 3000 may be provided as a charging/discharging device. For example, the charging/discharging device, like the impedance measuring device 1000, may be connected to the other ends of a plurality of measurement pins, one ends of which are in contact with the positive and negative electrodes of the battery cell. In other words, the charging/discharging device may be electrically connected to the positive and negative electrodes of the battery cell, respectively. Thereafter, the charge/discharge device may charge and discharge the battery cell according to predefined heat generation conditions. Accordingly, the metal portion within the battery cell may generate heat. Here, the heat generation condition may include at least one condition information of a magnitude of the charge/discharge current, a charge/discharge time, and an external temperature to minimize the temperature change of the electrolyte in the battery cell. Here, the magnitude of the charge/discharge current may vary depending on a number and a size of tabs which are metal portions in the battery cell.

The heat generation device 3000 is not limited to the disclosed charging/discharging device, and may be applied as various devices that can induce heat generation in one or more metal portions within a battery cell.

The defect inspection apparatus 5000 may be connected with at least one of the impedance measurement device 1000 and the heat generation device 3000. Accordingly, the defect inspection apparatus 5000 may obtain a first resistance value and a second resistance value measured before and after heat generation of a battery cell from the impedance measurement device 1000.

According to embodiments, the first resistance value may be a real part of an impedance value corresponding to a predefined frequency among the frequency-specific impedance values measured on the battery cell by the impedance measurement device 1000 before the heat generation.

Additionally, the second resistance value may be a real part of an impedance value corresponding to a predefined frequency among the frequency-specific impedance values measured by the impedance measurement device 1000 after generating heat in the battery cell.

Here, the predefined frequency may be defined as a specific frequency higher than a predefined reference frequency. For example, the first resistance value and the second resistance values may be real parts of the impedance values at 850Hz, which is one of the frequencies in the high frequency range above 600Hz, the reference frequency.

Thereafter, the defect inspection apparatus 5000 may compare the first resistance value and the second resistance value to determine whether a defect occurs in the metal portion within the battery cell. Here, the metal portion may include at least one of a tab and a lead inside the battery cell. Additionally, defects in the metal portion may include at least one of welding defects between tabs, welding defects between tabs and leads, and disconnection of tabs.

In the case of metals, as the temperature increases, the number of collisions of electrons increases, the frequency of atoms increases, and the resistance value may increase. Here, according to one embodiment, when a welding defect (such as a welding defect between tabs or a welding defect between a tab and a lead) or a complete disconnection (such as a tab disconnection) occurs in a metal portion, which leads to a contact resistance between the tabs or the tab and the lead, the resistance value may increase by a larger amount (approximately 1~3% in the case of a disconnection) compared to a normal battery cell. Thus, the defect inspection apparatus according to embodiments of the present invention may measure the impedance change of a metal portion in a battery cell before and after heat generation and amplify the micro-resistance values in weak welds and tab disconnections that are difficult to detect, thereby enabling stable detect of these defects.

Meanwhile, the defect inspection apparatus 5000 may include heat generation conditions according to attribute information of the battery cell. Accordingly, when heat is induced in a metal portion within a battery cell, the defect inspection apparatus 5000 may transmit a heat generation condition corresponding to attribute information of the battery cell to the heat generation device 3000. Thus, the heat generation device 3000 may generate heat in the metal portion of the battery cell under predefined condition values that minimize the temperature change of electrolyte in the battery cell.

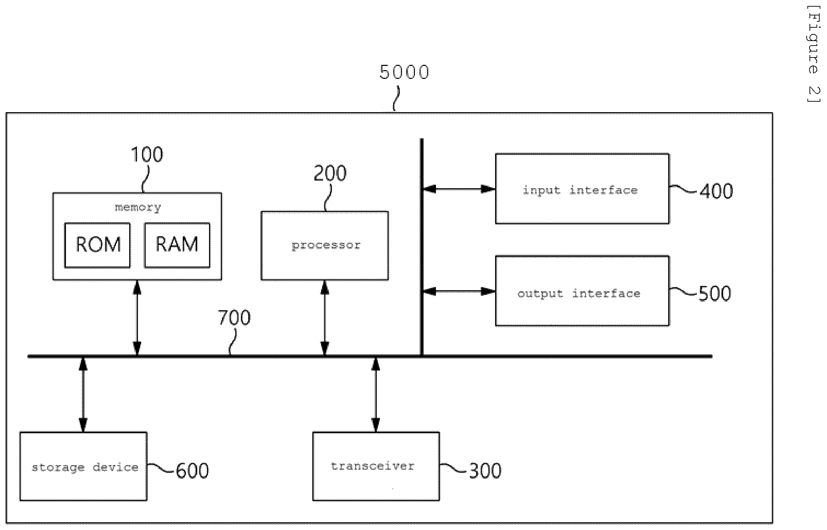

FIG. 2 is a block diagram of a processor in the defect inspection apparatus according to embodiments of the present invention.

Referring to FIG. 2, the defect inspection apparatus 5000 may include a memory 100, a processor 200, a transceiver 300, an input interface 400, an output interface 500, and a storage device 600.

According to embodiments, respective components (100, 200, 300, 400, 500, 600) included in the defect inspection apparatus 5000 may be connected by a bus 700 to communicate with each other.

The memory 100 and the storage device 600 among the components (100, 200, 300, 400, 500, 600) of the defect inspection apparatus 5000 may include at least one of a volatile storage medium and a non-volatile storage medium. For example, the memory 100 and the storage device 600 may include at least one of read only memory (ROM) and random access memory (RAM).

Among them, the memory 100 may include at least one instruction executed by the processor 200.

According to embodiments, the at least one instruction may include an instruction to calculate a difference between resistance values measured before and after inducing heat generation of a metal portion in the battery cell; and an instruction to compare the difference with a predetermined reference value to determine whether a defect occurs in the metal portion.

Here, the instruction to calculate the difference between the resistance values may include an instruction to obtain a first resistance value of the metal portion before inducing the heat generation; an instruction to induce heat generation in the metal portion according to heat generation condition; an instruction to obtain a second resistance value of the metal portion where the heat generation is induced; and an instruction to compare the first resistance value and the second resistance value to calculate the difference.

Here, the heat generation condition may include at least one condition value that ensures that a temperature change of an electrolyte in the battery cell is maintained below a predetermined reference level.

In addition, the instruction to induce heat generation in the metal portion according to the heat generation condition may include an instruction to induce heat generation in the metal portion by charging and discharging the battery cell according to the heat generation condition.

For, example, the heat generation condition includes at least one of a magnitude of a charge/discharge current, a charge/discharge time, and external temperature, for charging and discharging the battery cell.

Here, the heat generation condition may vary according to information on attributes of the battery cell.

Meanwhile, the resistance values may be values of real part in impedance values measured at a predefined frequency.

Furthermore, the instruction to compare the difference with a predetermined reference value to determine whether a defect occurs in the metal portion includes: an instruction to, upon the difference being greater than or equal to the reference value, determine that a defect has occurred in the metal portion; and an instruction to, upon the difference being less than the reference value, determine that the battery cell is normal.

Meanwhile, the processor 200 may mean a central processing unit (CPU), a graphics processing unit (GPU), or a dedicated processor on which methods according to embodiments of the present invention are performed.

The processor 200 may execute at least one program command stored in the memory 100 as described above.

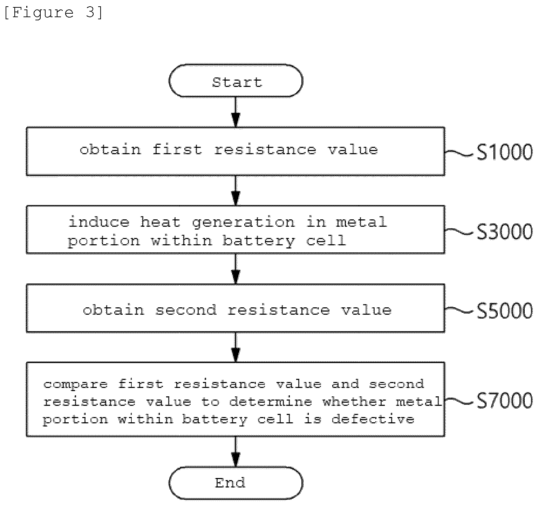

FIG. 3 is a flowchart for explaining a method of inspecting a battery cell for defects using a defect inspection apparatus according to embodiments of the present invention.

Referring to FIG. 3, the processor 200 in the defect inspection apparatus 5000 may obtain a first resistance value measured from the battery cell which is an inspection target (S1000). Here, the battery cell may be a battery cell in which heat generation is not induced in the metal portion.

In addition, the first resistance value may be a real part of an impedance value corresponding to a predefined frequency. Here, the predefined frequency may be defined as a specific frequency higher than a predefined reference frequency. For example, the specific frequency may be 850Hz, which is one of the frequencies in a high frequency range above the reference frequency of 600Hz.

According to an embodiment, the processor 200 may receive impedance values for each frequency from the impedance measurement device 1000 through a transceiver 300. Thereafter, the processor 200 may obtain the first resistance value by obtaining the real part of the impedance measured at the predefined frequency among the received impedance values.

According to another embodiment, the processor 200 may receive and obtain the first resistance value, which is the real part of the impedance value corresponding to the predefined frequency, from the impedance measurement device 1000 through the transceiver 300.

Thereafter, the processor 200 may operate the heat generation device 3000 to induce heat generation in the metal portion within the battery cell (S3000).

According to embodiments, the processor 200 may transmit at least one heat generation condition and an operation signal to the heat generation device 3000 using the transceiver 300. Here, the heat generation condition may be predefined condition values to minimize the temperature change of the electrolyte within the battery cell. According to embodiments, when the heat generation device 3000 is a charging/discharging device, the heat generation condition may include at least one of a magnitude of the charging/discharging current, charging/discharging time, and the external temperature which are predefined to minimize the temperature change of the electrolyte in the battery cell.

For example, the heat generation condition may be pre-stored in the memory 100 in the form of a table of at least one condition value according to attribute information of the battery cell. Accordingly, the processor 200 may obtain heat generation condition corresponding to attribute information of the battery cell which is an inspection target and transmit the heat generation condition to the heat generation device 3000.

Thereafter, the processor 200 may obtain a second resistance value measured from the heat-generating battery cell (S5000). In other words, the battery cell may be in a state which heat generation from a metal portion within the battery cell is intentionally induced by the heat generation device 3000.

The second resistance value may be real part of an impedance value corresponding to a predefined frequency. Here, the predefined frequency may be defined as a specific frequency higher than a predefined reference frequency. For example, the specific frequency may be 850Hz, which is one of the frequencies in the high frequency range above the reference frequency of 600Hz.

According to one embodiment, the processor 200 may receive frequency-specific impedance values of the battery cell in which a metal portion generates heat, which are measured by the impedance measurement device 1000, through the transceiver 300. Thereafter, the processor 200 may obtain the second resistance value by obtaining the real part of the impedance measured at the predefined frequency among the received impedance values.

According to another embodiment, the processor 200, may receive the second resistance value, which is the real part of the impedance value corresponding to the predefined frequency among frequency-specific impedance values of a battery cell in which a metal portion generates heat, from the impedance measurement device 1000 through the transceiver 300.

Thereafter, the processor 200 may compare the first resistance value and the second resistance value to determine whether the metal portion within the battery cell is defective (S7000).

In more detail, the processor 200 may calculate the difference between the first resistance value and the second resistance value. Thereafter, the processor 200 may compare the difference with a predefined reference value. Here, the reference values may vary depending on the number of and sizes of tabs, which may be metal portions, in the battery cell. For example, the reference value may be 0.007mΩ.

According to one embodiment, when the difference is greater than or equal to the reference value, the processor 200 may determine that a defect has occurred in the metal portion of the battery cell.

According to another embodiment, when the difference is less than the reference value, the processor 200 may determine that there is no abnormality in the metal portion of the battery cell.

### Method for inspecting defective battery cells according to experimental examples of the present invention

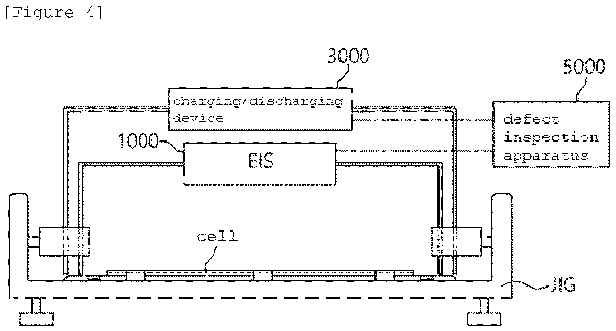

FIG. 4 is a conceptual diagram of a defect inspection system for inspecting a pouch-type battery cell according to an experimental example of the present invention.

As shown in FIG. 4, normal cells and defective battery cells of the same model including 20 tabs were prepared and provided in the form of a pouch. Here, the defective battery cell is a battery cell with a 35mm disconnection in the tab.

First, a normal battery cell was fixed to a jig-shaped fixture. Afterwards, using the impedance measurement device 1000, an alternating voltage was applied to both terminals of the electrodes of the normal battery cell. Thereafter, while changing the frequency from 1Khz to 400hz, an impedance value at a predefined reference frequency was first measured before heat generation.

Afterwards, the heat generation condition corresponding to the attribute information of the normal battery cell was determined using the charging/discharging device which is a heat generation device 3000.

According to the heat generation condition, the external temperature was set to 22°C, and charging and discharging was performed by applying charging and discharging currents of 60A for 5 seconds, respectively.

Thereafter, using the impedance measurement device 1000, the impedance value at the predefined reference frequency of the normal battery cell was again measured for the second time.

Thereafter, under the same conditions as the normal battery cell, the impedance values at the predefined reference frequency of the defective battery cell before and after heat generation were measured, respectively.

Thereafter, using the defect inspection apparatus 5000, normal battery cells and defective battery cells were inspected for defects in the metal portions, respectively.

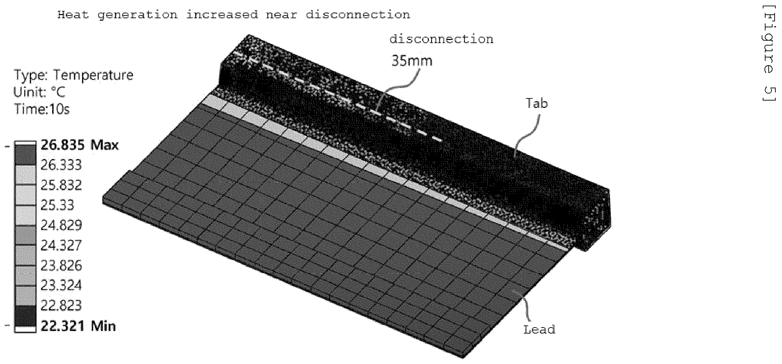

FIG. 5 is an image measuring the temperature of a defective battery cell when heat is induced according to an experimental example of the present invention.

Referring to FIG. 5, as a result of measuring temperatures of the entire metal tabs of a normal battery cell after charging and discharging, 25.038°C was obtained as an average temperature whereas as a result of measuring temperatures of the entire tabs of a defective battery cell after charging and discharging, 26.393°C was obtained as an average temperature. In other words, it can be understood that the average temperature after charging and discharging of the defective battery cell is 1.355°C higher than the average temperature after charging and discharging of the normal battery cell.

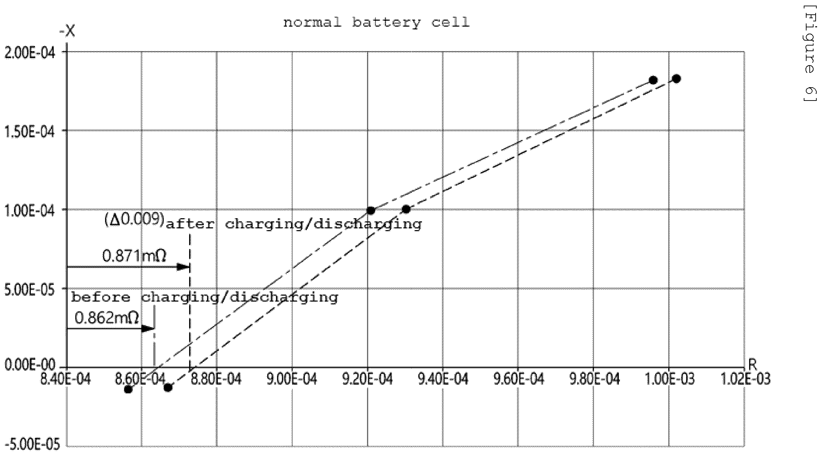

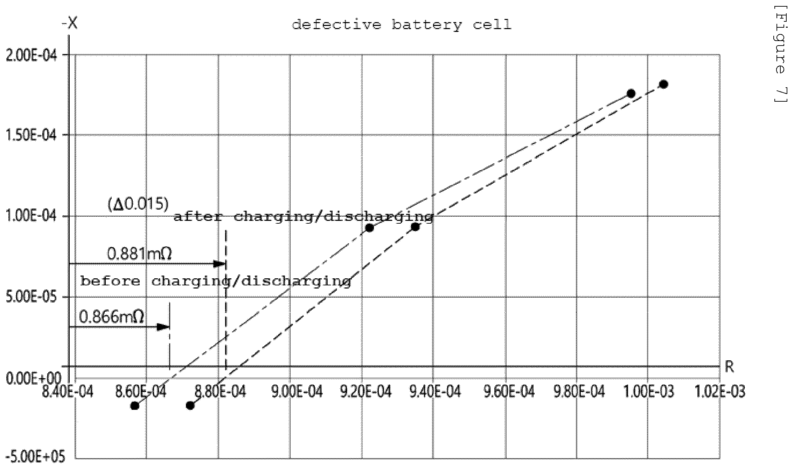

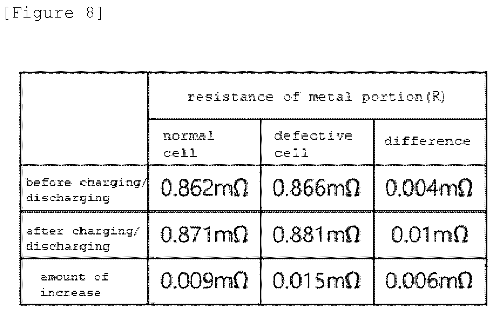

FIG. 6 is a graph of impedance measurement results per frequency of a normal battery cell before and after heat generation according to an experimental example of the present invention. FIG. 7 is a graph of impedance measurement results per frequency of a defective battery cell before and after heat generation according to another experimental example of the present invention. FIG. 8 is a table summarizing resistance values before and after heat generation of normal battery cells and defective battery cells according to experimental examples of the present invention.

In FIGS. 6 to 8, according to the impedance measurement graphs for each frequency of a normal battery cell and a defective battery cell, a clear difference is shown in the real part value of the impedance before the charging/discharging and the real part value of the impedance after the charging/discharging, in the high frequency region above the reference frequency (fs).

Accordingly, based on the value of the real part of the impedance at a predefined frequency in the normal battery cell and the value of the real part of the impedance at a predefined frequency in the defective battery cell, the difference before and after inducing heat using the charging and discharging device was examined. The real part value of impedance of the normal battery cell before charging/discharging was 0.862mΩ, and the real part value of the impedance of the defective battery cell before charging/discharging was 0.866mΩ. In other words, it can be understood that the real part of the impedance of the defective battery cell before charging/ discharging is larger by 0.004 mΩ than the real part of the impedance of the normal battery cell before charging/discharging.

In addition, the real part of the impedance of a normal battery cell after charging/discharging is 0.871mΩ and the real part of the impedance of a defective battery cell before charging/discharging is 0.881mΩ, by which can be understood and the real part of the impedance of a defective battery cell after charging/discharging is larger by 0.01mΩ than that of a normal battery cell.

In addition, the increase in the real part of the impedance of a normal battery cell before and after charging and discharging is 0.009mΩ whereas the increase in the real part of the impedance of a defective battery cell before and after charging and discharging is 0.015mΩ, which means that the increase in the real part of the impedance of a defective battery cell is larger by 0.006mΩ than the increase in the real part of the impedance of a normal battery cell.

Accordingly, as a result of comparing the impedance difference between a normal battery cell and a defective battery cell, it can be understood that the difference (0.01 mΩ) between the normal battery cell and the defective battery cell in the real part of the impedance measured after inducing heat in the metal portion by charging/discharging has increased by 2.5 times compared to the difference (0.004mΩ) between the normal battery cell and the defective battery in the real part of the impedance measured without inducing heat generation in the metal portion. In addition, the difference of change (0.006mΩ) in the real part of the impedance before and after charging/discharging of the normal battery cell and the change in the real part of the impedance before and after charging/discharging of the defective battery cell shows 1.5 times greater than the difference of change (0.004mΩ) between the normal battery cell and the defective battery cell in the real part of the impedance measured without inducing any heat.

In summary, it can be understood that the impedance difference between a normal battery cell and a defective battery cell shows the largest difference in the real part value of the impedance measured at the reference frequency range after heat generation is induced in the metal portion.

Therefore, the method for inspecting defective battery cells according to experimental examples of the present invention may intentionally induce heat generation in the metal portion of a battery cell and determine whether the metal portion of the battery cell is defective based on the amount of change in the real part of the impedance before and after the heat generation, thereby enabling detection of a defect in the metal portion with high precision.

An apparatus and method for inspecting defective battery cells according to embodiments and experimental examples of the present invention, and a system including the apparatus have been described.

The apparatus and method for inspecting defective battery cells according to embodiments and experimental examples of the present invention, and a system including the apparatus, may induce heat generation in metal portion of a battery cell using a heat generation device and determine whether the metal portion of the battery cell is defective based on the amount of change in the impedance before and after the heat generation, and thus, detection ability can be improved even for micro defects such as weak welding or disconnection of a tab portion by increasing the resistance value of the metal portion where a defect occurred due to heat generation.

The operations of the method according to the embodiments and experimental examples of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

In addition, the computer-readable recording medium may include hardware devices specially configured to store and execute program instructions, such as ROM, RAM, flash memory, etc. The program instructions may include not only machine language code created by a compiler, but also high-level language code that can be executed by a computer using an interpreter.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. A defect inspection method of a battery cell, the defect inspection method of the battery cell comprising:
calculating a difference between resistance values measured before and after inducing heat generation of a metal portion in the battery cell; and
comparing the difference with a predetermined reference value to determine whether a defect occurs in the metal portion.

2. The defect inspection method of the battery cell of claim 1, wherein the calculating the difference between the resistance values includes:
obtaining a first resistance value of the metal portion before inducing the heat generation;
inducing heat generation in the metal portion according to heat generation condition;
obtaining a second resistance value of the metal portion where the heat generation is induced; and
comparing the first resistance value and the second resistance value to calculate the difference.

3. The defect inspection method of the battery cell of claim 1, wherein the heat generation condition includes at least one condition value that ensures that a temperature change of an electrolyte in the battery cell is maintained below a predetermined reference level.

4. The defect inspection method of the battery cell of claim 2, wherein the inducing heat generation in the metal portion according to the heat generation condition includes inducing heat generation in the metal portion by charging and discharging the battery cell according to the heat generation condition.

5. The defect inspection method of the battery cell of claim 4, wherein the heat generation condition includes at least one of a magnitude of a charge/discharge current, a charge/discharge time, and external temperature, for charging and discharging the battery cell.

6. The defect inspection method of the battery cell of claim 3, wherein the heat generation condition differs according to information on attributes of the battery cell.

7. The defect inspection method of the battery cell of claim 1, wherein the resistance values are values of real part in impedance values measured at a predefined frequency.

8. The defect inspection method of the battery cell of claim 1, wherein the comparing the difference with a predetermined reference value to determine whether a defect occurs in the metal portion includes:
upon the difference being greater than or equal to the reference value, determining that a defect has occurred in the metal portion; and
upon the difference being less than the reference value, determining that the battery cell is normal.

9. A defect inspection apparatus of a battery cell comprising:
at least one processor; and
a memory configured to store at least one instruction executed by the at least one processor,
wherein the at least one instruction includes:
an instruction to calculate a difference between resistance values measured before and after inducing heat generation of a metal portion in the battery cell; and
an instruction to compare the difference with a predetermined reference value to determine whether a defect occurs in the metal portion.

10. The defect inspection apparatus of the battery cell of claim 9, wherein the instruction to calculate the difference between the resistance values includes:
an instruction to obtain a first resistance value of the metal portion before inducing the heat generation;
an instruction to induce heat generation in the metal portion according to heat generation condition;
an instruction to obtain a second resistance value of the metal portion where the heat generation is induced; and
an instruction to compare the first resistance value and the second resistance value to calculate the difference.

11. The defect inspection apparatus of the battery cell of claim 9, wherein the heat generation condition includes at least one condition value that ensures that a temperature change of an electrolyte in the battery cell is maintained below a predetermined reference level.

12. The defect inspection apparatus of the battery cell of claim 10, wherein the instruction to induce heat generation in the metal portion according to the heat generation condition includes an instruction to induce heat generation in the metal portion by charging and discharging the battery cell according to the heat generation condition.

13. The defect inspection apparatus of the battery cell of claim 12, wherein the heat generation condition includes at least one of a magnitude of a charge/discharge current, a charge/discharge time, and external temperature, for charging and discharging the battery cell.

14. The defect inspection apparatus of the battery cell of claim 11, wherein the heat generation condition differs according to information on attributes of the battery cell.

15. The defect inspection apparatus of the battery cell of claim 9, wherein the resistance values are values of real part in impedance values measured at a predefined frequency.

16. The defect inspection apparatus of the battery cell of claim 9, wherein the instruction to compare the difference with a predetermined reference value to determine whether a defect occurs in the metal portion includes:
an instruction to, upon the difference being greater than or equal to the reference value, determine that a defect has occurred in the metal portion; and
an instruction to, upon the difference being less than the reference value, determine that the battery cell is normal.

17. A defect inspection system of a battery cell comprising:
an impedance measurement device configured to measure a resistance value of a battery cell;
a heat generation device configured to induce heat generation from a metal portion of the battery cell; and
a defect inspection apparatus of a battery cell configured to determine whether a defect occurs in the metal portion of the battery cell,
wherein the defect inspection apparatus of a battery cell is further configured to:
calculate difference between resistance values which are measured before and after inducing heat in the metal portion by the impedance measuring device; and
compare the difference with a predetermined reference value to check whether a defect occurs in the metal portion.

18. The defect inspection system of the battery cell of claim 17, wherein the defect inspection apparatus of a battery cell is further configured to:
obtain a first resistance value of the metal portion from the impedance measuring device before inducing heat in the metal portion;
transmit heat generation condition to the heat generation device to induce heat generation in the metal portion;
obtain a second resistance value of the metal portion in which the heat generation is induced from the impedance measuring device; and
compare the first resistance value and the second resistance value to calculate the difference, to determine whether a defect occurs in the metal portion.

19. The defect inspection system of the battery cell of claim 18, wherein the heat generation condition includes at least one condition value that ensures that a temperature change of an electrolyte in the battery cell is maintained below a predetermined reference level.

20. The defect inspection system of the battery cell system of claim 17, wherein the heat generation device includes a charging/discharging device.

21. The defect inspection system of the battery cell system of claim 17, wherein the resistance values are values of real part in impedance values measured at a predefined frequency.
